# FASCICULE DE BREVET EUROPEEN

(11) **EP 1 952 097 B1**
(45) Date de publication et mention de la délivrance du brevet: **29.06.2016**
(21) Numéro de dépôt: 06831154.7
(22) Date de dépôt: 22.11.2006
(51) Int. Cl.: G01D 5/241

(54) **DISPOSITIF ET PROCEDE DE MESURE CAPACITIVE PAR PONT FLOTTANT**
VORRICHTUNG UND VERFAHREN ZUR KAPAZITIVEN MESSUNG ÜBER EINE POTENTIALFREIE BRÜCKE
DEVICE AND METHOD FOR CAPACITIVE MEASUREMENT BY A FLOATING BRIDGE

(30) Priorité: 24.11.2005 FR 0511916
(43) Date de publication de la demande: 06.08.2008
(73) Titulaire: Nanotec Solution, 30900 Nîmes (FR)
(72) Inventeur: OSSART, Frédéric, F-30900 Nîmes (FR); ROZIERE, Didier, F-30900 Nîmes (FR)
(74) Mandataire: Pontet Allano & Associes
(86) Numéro de dépôt international: PCT/FR2006/002566
(87) Numéro de publication internationale: WO 2007/060324

(56) Documents cités:
- FR-A- 2 756 048
- FR-A- 2 844 048
- FR-A- 2 844 349
- MICHAL BRYCHTA: "Measure Capacitive Sensors with a Sigma-Delta Modulator"[Online] 28 avril 2005 (2005-04-28), XP002388128 Extrait de l'Internet: URL:http://www.elecdesign.com/Articles/Pri nt.cfm?ArticleID=10185> [extrait le 2006-06-30]
- ANALOG DVICES INC.: "24-Bit Capacitance-to-Digital Converter with Temperature Sensor AD7745/AD7746" ANALOG DEVICE INC, avril 2005 (2005-04), XP002388296

## Description

### Domaine technique

La présente invention concerne un dispositif de mesure capacitive par pont flottant. Elle vise également un procédé de mesure capacitive par pont flottant, mis en oeuvre dans ce dispositif.

Le domaine de l'invention est celui de la mesure de déplacement, de distance et de la métrologie dimensionnelle, et plus généralement des équipements d'instrumentation mettant en oeuvre des mesures capacitives.

### Etat de la technique antérieure

En métrologie capacitive, les capacités à mesurer sont en général de très faible valeur et pour obtenir des mesures précises, il est nécessaire de minimiser les capacités parasites liées à la liaison entre le capteur et l'électronique et à l'étage d'entrée de cette électronique.

Le document FR9613992 décrit un procédé qui supprime ces capacités parasites en utilisant une électronique alimentée par une source de tension continue flottante à haut isolement électrique résistif et capacitif par rapport à la terre, l'ensemble étant inclus dans une garde portée au potentiel de la garde du capteur. Cette électronique utilise un amplificateur de charge comme étage d'entrée, une excitation sinusoïdale ou carrée, un démodulateur synchrone et un modulateur afin d'effectuer une mesure de capacité ou une mesure de l'inverse de capacité.

Entre-temps, les fabricants de circuit intégrés ont fait d'énormes progrès en performances analogique et en miniaturisation. Ainsi, des fabricants, tels que la société Analog Device, proposent des puces électroniques possédant une fonction complète de mesure capacitive.

Le document FR2756048 décrit un pont de mesure capacitif selon l'état de l'art.

Certain de ces circuits génèrent une pseudo garde pour limiter les capacités de fuite mais ne les éliminent pas suffisamment pour pouvoir les utiliser dans le domaine de la métrologie dimensionnelle de précision. En effet les technologies actuelles pour réaliser ces circuits intégrés ne permettent pas de réaliser une garde compatible avec les besoins en métrologie capacitive.

Le but de l'invention est de proposer un nouveau dispositif de mesure capacitive par pont flottant, permettant d'allier les performances d'un montage capacitif flottant de très haute précision et le faible coût de réalisation induit par l'utilisation de circuits intégrés de mesure capacitive proposés pour des applications de faible ou moyenne précision.

### Exposé de l'invention

Cet objectif est atteint avec un dispositif de mesure capacitive par pont flottant, Z tel que celui décrit dans la revendication 1.

Les moyens d'alimentation flottante sont de préférence agencés pour procurer une isolation galvanique du circuit intégré de mesure capacitive, par rapport à une source de tension extérieure à la garde.

Le dispositif de mesure capacitive selon l'invention peut en outre avantageusement comprendre des moyens d'amplification différentielle pour générer, à partir du signal de sortie du circuit intégré de mesure capacitive, un signal de sortie en référence à la masse générale.

Il peut en outre comprendre des moyens amplificateurs disposés entre la sortie d'excitation du circuit intégré de mesure capacitive et la masse générale, ainsi que des moyens pour alimenter les moyens d'amplification à une tension plus élevée que celle du circuit intégré de mesure capacitive.

Dans une configuration d'un dispositif selon l'invention comprenant en outre une seconde électrode de garde concentrique entourant la première électrode de garde, la seconde électrode de garde concentrique est reliée à la masse générale.

Dans le cas où le module capteur comprend une première et une seconde électrodes de mesure sensiblement parallèles et entre lesquelles est située une électrode cible reliée à la masse générale, les première et seconde électrodes de mesure sont alors reliées respectivement à une première et à une seconde entrées du circuit intégré de mesure capacitive et sont entourées respectivement par des première et seconde électrodes de garde.

Les première et seconde électrodes de garde sont généralement reliées entre elles et à la garde via une liaison de garde commune.

Les première et seconde électrodes de garde sont par exemple reliées à la garde via respectivement une première et une seconde liaisons de garde.

Lorsque le dispositif de mesure capacitive selon l'invention comprend en outre une pluralité d'électrodes de mesure entourées par une électrode de garde reliée à la garde, on peut prévoir une première configuration dans laquelle le dispositif comprend en outre des moyens commutateurs reliés en entrée à la pluralité d'électrodes de mesure et en sortie à l'entrée du circuit intégré de mesure capacitive, situés à l'intérieur de la garde et commandés par des moyens de contrôle et de traitement.

Dans une seconde configuration, le dispositif de mesure capacitive selon l'invention comprend en outre une pluralité de circuits intégrés de mesure capacitive reliés chacun en entrée à une électrode de mesure et en sortie, ayant chacun leur sortie d'oscillateur reliée en entrée de premiers moyens commutateurs dont la sortie est reliée à la masse générale, et leur sortie de mesure reliée en entrée de seconds moyens commutateurs générant en sortie un signal de mesure capacitive multiplexé, lesdits premiers et seconds moyens commutateurs étant situés à l'intérieur de la garde et commandés par des moyens de contrôle et de traitement.

Le dispositif de mesure capacitive selon l'invention peut en outre comprendre des moyens optocoupleurs disposés entre les moyens commutateurs et les moyens de contrôle et de traitement.
Le circuit intégré de mesure capacitive peut avantageusement comprendre des moyens de conversion capacitive/numérique (CDC) à transfert de charges, ou encore un convertisseur capacitif-numérique Delta Sigma. Le circuit intégré de mesure capacitive peut être, soit situé à proximité des électrodes du module capteur, soit déporté des électrodes au moyen d'un câble coaxial ou triaxial. Il peut comprendre des entrées différentielles et être à garde unique, et comprendre des moyens d'alimentation flottante pour alimenter les composants disposés à l'intérieur de la garde, par exemple un module de conversion continu-continu DC-DC ou alternatif-continu AC-DC.

Ce module de conversion DC-DC peut par exemple comprendre un transformateur comportant, en tant que circuit primaire une bobine excitée par un signal alternatif référencé à une masse générale, et en tant que circuit secondaire, une bobine réceptrice connectée à des moyens redresseurs pour générer une tension continue flottante. Ce transformateur peut être du type « planar ».

L'alimentation flottante peut aussi être réalisée avec des selfs de choc séparant l'alimentation référencée à la masse générale de l'alimentation -flottante référencée à la garde. Ces selfs de choc peuvent être accordées sur la fréquence d'excitation des électrodes afin d'augmenter l'impédance des selfs de choc.

Dans une version miniaturisée, le dispositif de mesure capacitive selon l'invention est réalisé sous la forme d'un circuit imprimé sur lequel l'électrode de mesure est gravée, ledit circuit imprimé recevant le circuit intégré de mesure capacitive, les moyens d'alimentation flottante et des moyens de liaison du circuit intégré avec des équipements extérieurs.

Un dispositif de mesure capacitive selon l'invention peut être mis en oeuvre dans un système anti-collision, dans un système de reconnaissance de forme, dans un système de métrologie dimensionnelle, dans un biocapteur, dans un équipement de caractérisation de matériaux.

Il peut aussi être mis en oeuvre dans une jauge de contrainte, et être alors fixé sur un support de référence et présenter une électrode de mesure visant la surface d'une pièce subissant une déformation à mesurer.

Suivant un autre aspect de l'invention, il est proposé un procédé de mesure capacitive par pont flottant, tel que celui décrit dans la revendication 31.

La présente invention présente une solution pour générer une garde de qualité dont la fonctionnalité est compatible avec les circuits intégrés dédiés à la mesure capacitive. Un exemple de circuit intégré est le AD7745 et AD7746 de chez Analog Device. Ce circuit utilise un convertisseur delta sigma capacitif/numérique de haute résolution.

Un deuxième circuit dérivé des AD7745 et AD7746 est le AD7747 équipé d'une pseudo-garde mais utilise une tension d'alimentation unique sans tension flottante.

La première famille possède des performances en résolution et en fuite capacitive très bonnes mais elle ne mesure que des capacités dont l'une des deux électrodes est reliée à l'entrée du circuit intégré et la deuxième est reliée à un signal d'excitation généré par la puce. Dans ces conditions la capacité mesurée ou capteur est dit flottante. Cette puce peut effectuer des mesures de capacités dont l'une des deux électrodes est reliée à la masse électrique que si ce circuit est alimenté en flottant.

Le deuxième type de circuit à pseudo garde permet de mesurer des capacités dont l'une des deux électrodes est reliée à l'entrée de la puce électronique et la deuxième est reliée à la masse électrique. Les performances en fuite capacitive et en précision sont moins élevées que celles obtenues avec la première famille décrite dans le paragraphe précédent, car la garde est générée par une excitation non flottante.

Un exemple d'application non limitatif est l'utilisation d'un capteur multi électrodes de mesure de déplacement ou de détection d'objet sans contact. Ce type de procédé décrit dans la publication de demande de brevet « détecteur de proximité par capteur capacitif » n° 02 11089 utilise une électronique flottante équipée d'un scrutateur dit des moyens multiplexeurs placés entre les électrodes et l'entrée de l'électronique. Ces multiplexeurs possèdent des capacités parasites qui se superposent aux capacités à mesurer si l'électronique est dite non flottante avec ou sans pseudo garde.

Dans ces conditions, le seul moyen d'utiliser les puces à mesure capacitive disponibles sur le marché connectées à des capteurs multi électrodes est d'alimenter ces puces en tension flottante.

Un autre avantage de cette technique est la possibilité de placer des circuits électroniques flottants près des électrodes du capteur pour apporter de nouvelles fonctions comme par exemple une mesure de température.

Un autre avantage est la suppression de l'effet des charges capacitives et résistives parasites connectée à la puce via le capteur et le câble de liaison sur la mesure. En effet, les circuits intégrés Analog Device décrits ci-dessus présentent une mauvaise réjection des charges parasites résistives et capacitives présentes entre l'entée et la masse de la puce. Les courants de fuite générés par ces charges sont très fortement réduits voire éliminés par l'alimentation flottante.

Un autre avantage est la possibilité d'augmenter l'amplitude d'excitation de la capacité à mesurer en rajoutant un amplificateur entre la sortie excitation de la puce et la capacité à mesurer. Cet amplificateur peut être alimenté en tension plus élevée que celle de la puce grâce à l'alimentation flottante. L'augmentation de l'amplitude de cette excitation augmente d'autant la résolution de la mesure capacitive.

Les signaux de sortie de ce type de puce représentant la mesure sont en général numériques et peuvent être analogiques. Ils peuvent être transmis via des circuits optocoupleurs ou des amplificateur différentiels afin de conserver l'isolation du circuit flottant avec les circuits extérieurs.

### Description des figures et modes de réalisation

D'autres avantages et caractéristiques de l'invention apparaîtront à l'examen de la description détaillée de mises en oeuvre nullement limitatives, et des dessins annexés suivants :
- la figure 1 illustre un premier exemple de réalisation d'un dispositif de mesure capacitive selon l'invention, en montage flottant coaxial ;
- la figure 2 illustre un second exemple de réalisation d'un dispositif de mesure capacitive selon l'invention, en montage flottant triaxial ;
- la figure 3 illustre une première version d'un troisième exemple de réalisation d'un dispositif de mesure capacitive selon l'invention, en montage flottant différentiel ;
- la figure 4 illustre une seconde version du troisième exemple de réalisation d'un dispositif de mesure capacitive selon l'invention,
- la figure 5 illustre une première version d'un quatrième exemple de réalisation d'un dispositif de mesure capacitive selon l'invention, dans un montage multi-électrodes commutées ;
- la figure 6 illustre une seconde version du quatrième exemple de réalisation, dans un montage multi-électrodes multi-circuits intégrés ; et
- la figure 7 illustre schématiquement un exemple de configuration d'un capteur de déplacement implémentant un dispositif de mesure capacitive selon l'invention.

Dans la description qui suit en référence aux figures précitées, les composants et modules communs à plusieurs exemples de réalisation ou versions de dispositif de mesure capacitive selon l'invention présentent des numéros de référence identiques.

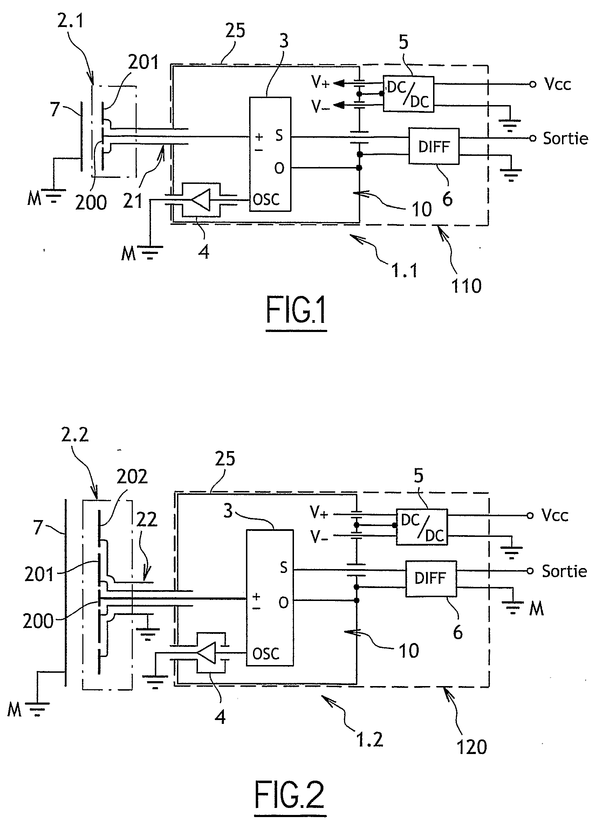

On va tout d'abord décrire, en référence à la figure 1, un premier exemple de réalisation d'un dispositif de mesure capacitive selon l'invention, en montage coaxial.

Ce dispositif de mesure capacitive 1.1 comprend un circuit intégré de mesure capacitive 3 comprenant nominalement une première entrée (+), une seconde entrée (-), une sortie OSC délivrant un signal oscillateur, une sortie de mesure S, une borne de masse. L'entrée (+) est connectée à une électrode centrale 200 d'un module 21 d'électrodes de mesure disposé à proximité d'une électrode cible 7 et pourvu d'une électrode de garde concentrique 201 reliée à une garde 25 entourant le circuit intégré de mesure capacitive 3 dont la sortie OSC est reliée via un amplificateur gardé 4 à la masse générale M du dispositif de mesure 1.1 à laquelle l'électrode de cible 7 est aussi reliée.

Le circuit intégré de mesure capacitive 3 et l'amplificateur d'oscillation 4, qui sont implantés sur un circuit imprimé 10 sont alimentées en tension continue (V+, V-) par un convertisseur continu/continu (DC/DC) ou alternatif/continu (AC/DC) 5 relié à la garde 25 et dont l'entrée est connectée à une source de tension Vcc. Le module d'électrodes de mesure 21 est relié au circuit imprimé 10 par un câble coaxial 21. La sortie S du circuit intégré de mesure capacitive 3 est reliée à une première entrée d'un amplificateur différentiel 6 dont la seconde entrée est reliée à la garde 25. Cet amplificateur différentiel 6 délivre en sortie un signal de mesure capacitive. Les circuits 3, 4 à l'intérieur de la garde 25, le convertisseur DC/DC 5 et l'amplificateur différentiel sont en pratique situés sur une plaque de circuit imprimé 110. Si le signal de sortie S est de type numérique et non analogique, alors, l'amplificateur différentiel peut être remplacé par un optocoupleur.

Dans un seconde exemple de réalisation d'un dispositif 1.2 de mesure capacitive selon l'invention, illustré par la figure 2, l'agencement des composants électroniques est identique à celui du premier exemple qui vient d'être décrit, mais son module d'électrodes de mesure 2.2 est relié au circuit imprimé 10 par un câble triaxial 22, et comprend, outre l'électrode centrale 200 reliée à l'entrée (+) du circuit intégré 3, une première électrode de garde 201 reliée à la garde 25, et une seconde électrode de garde 202 reliée à la masse générale du dispositif de mesure capacitive 1.2.

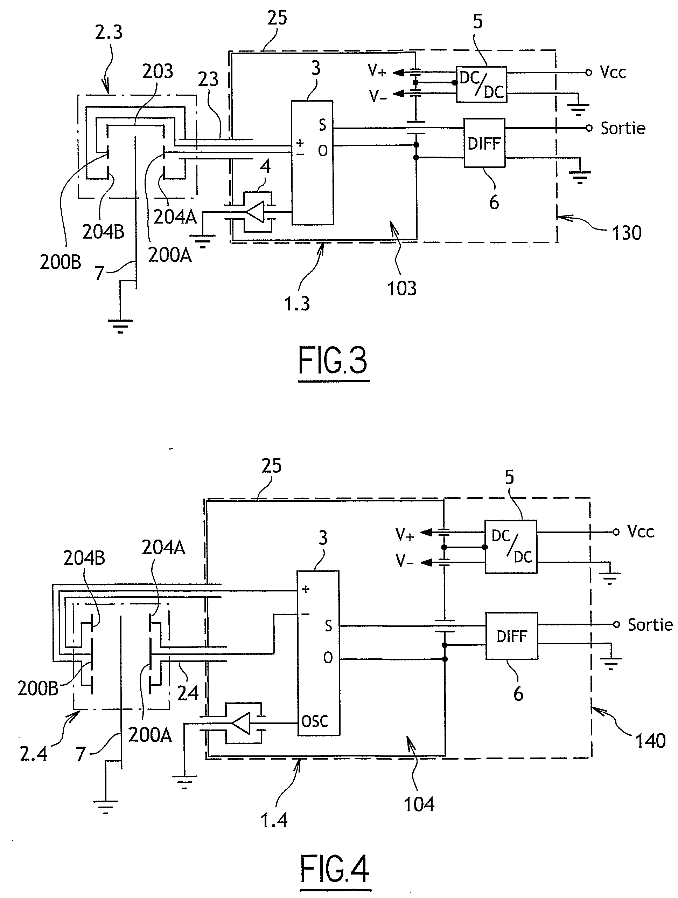

Dans un troisième exemple de réalisation d'un dispositif de mesure capacitive selon l'invention illustré par les figures 3 et 4, le module d'électrodes est de structure différentielle.

Dans une première version (Figure 3) de cet exemple de réalisation, le module d'électrodes 2.3 du dispositif de mesure 1.3 comprend un premier sous-ensemble et un second sous-ensemble d'électrodes comprenant respectivement une première et une seconde électrodes centrales 200A, 200B disposées de part et d'autre de l'électrode 7, et une première et une seconde électrodes de garde 204A, 204B entourant chacune une électrode centrale 200A, 200B. Les deux électrodes de garde 204A, 204B sont reliées via un câble 23 à la garde 25 tandis que les première et seconde électrodes centrales 200A, 200B sont reliées respectivement aux entrées (+) et (-) du circuit intégrée 3.

Dans une seconde version (Figure 4) de cet exemple de réalisation, le module d'électrodes 2.4 du dispositif de mesure 1.4 comprend un premier sous-ensemble et un second sous-ensemble d'électrodes comprenant respectivement une première électrode centrale de mesure 200A reliée à l'entrée (-) du circuit intégré 3 et une seconde électrode centrale de mesure 200B reliée à l'entrée (+) du circuit intégré 3. Ces deux électrodes centrales de mesure 200A, 200B sont disposées en vis-à-vis et définissent un espace à l'intérieur duquel est située une électrode cible 7 dont le déplacement est à mesurer. Les électrodes centrales de mesure 200A, 200B sont entourées respectivement par des électrodes de garde 204A, 204B qui sont reliées à la garde 25 via respectivement un premier câble de liaison 24A et un second câble de liaison 24B.

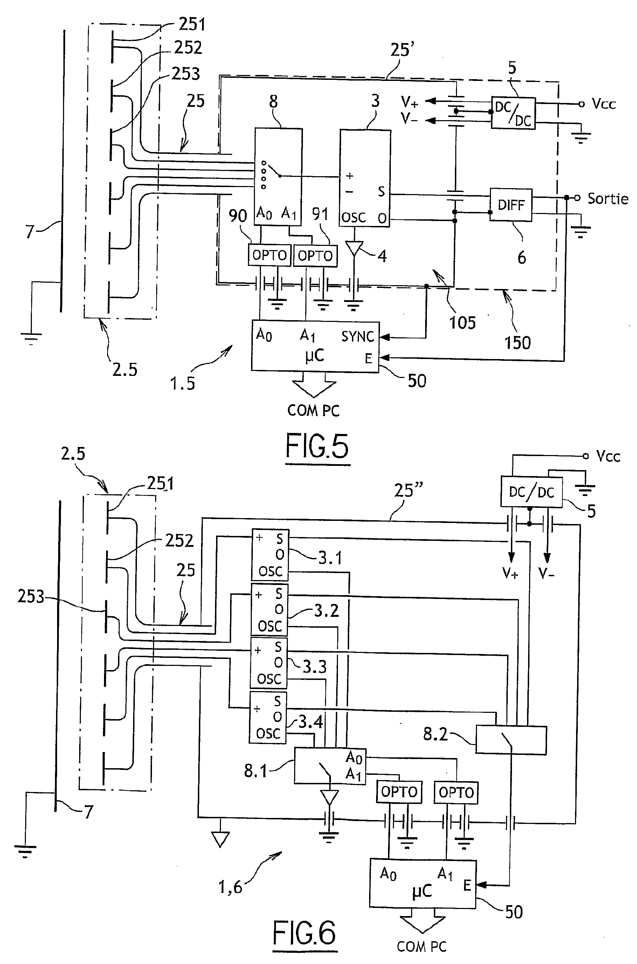

Dans un quatrième exemple de réalisation illustré par les figures 5 et 6, les dispositifs de mesure capacitive 1.5, 1.6 sont pourvus d'un module multi-électrodes 2.5 comprenant quatre électrodes de mesure 252, 253, 254, 254 entourées par une électrode de garde 251 concentrique, et disposé à proximité d'une électrode cible 7.

Dans une première version (Figure 5), du type « multi-électrodes commutées », le dispositif de mesure capacitive 1.5 comprend, à l'intérieur d'une garde 25' à laquelle l'électrode de garde 251 est reliée via un câble de liaison 256, un circuit commutateur 8 dont les entrées sont reliées à chacune des électrodes de mesure 252-255 du module d'électrodes 2.5 et dont la sortie est reliée à l'entrée (+) du circuit intégré de mesure capacitive 3.

Le commutateur 8, qui assure une fonction de multiplexage, est commandé à partir d'entrées de sélection (Ao, A1) reliées via des circuits optocoupleurs 90, 91, à deux sorties d'un microcontrôleur 50 disposé à l'extérieur de la garde 25'. Ce microcontrôleur 50 comporte une entrée de synchronisation SYNC reliée à la garde 25' et une entrée E reliée à la sortie de l'amplificateur différentiel 6. Le microcontrôleur 50 est connecté via un bus de communication à un poste informatique externe.

Dans une seconde version (Figure 6), du type « multi-électrodes multi-circuits intégrés », le dispositif de mesure capacitive 1.6 comprend, à l'intérieur d'une garde 25" à laquelle l'électrode de garde 251 est reliée, quatre circuits intégrés de mesure capacitive 3.1, 3.2, 3.3, 3.4 dont les entrées (+) respectives sont reliées aux quatre électrodes de mesure 252-255 et dont les sorties d'oscillateur OSC sont reliées à des entrées d'un premier commutateur 8.1 dont la sortie est reliée via un amplificateur 4 à la masse générale du dispositif capacitive 1.6.

Le dispositif de mesure capacitive 1.6 comprend aussi un seconde commutateur 8.2 dont les entrées sont connectées aux sorties S respectives des quatre circuits intégrés de mesure capacitive 3.1-3.4. Les deux premier et second commutateurs 8.1, 8.2 sont commandés via des optocoupleurs 90, 91 par le microcontrôleur 50 qui reçoit en entrée le signal de sortie délivré par le second commutateur 8.2. Le microcontrôleur peut être flottant et dans ces conditions les optocoupleurs sont connectés au niveau de la ligne "COM PC".

Un exemple de réalisation du convertisseur continu/continu (DC-DC) 5 consiste à graver des bobines sur du circuit imprimé avec des méthodes classiques industrielles. Au moins une bobine excitée par un signal alternatif référencé à la masse générale représente un circuit primaire d'un transformateur et au moins une bobine réceptrice formant un circuit secondaire et générant, après redressement filtrage voire régulation, une tension continue représentant la tension continue flottante pour alimenter l'électronique flottante. Ce procédé de réalisation est de type « transformateur planar » bien connu basé sur l'utilisation de bobines plates gravées sur du circuit imprimé en multicouche, bobines superposées et souvent de forme en spirales. Ce transformateur assurant l'isolement galvanique de DC-DC peut être amélioré en rendement, en utilisant une ferrite.

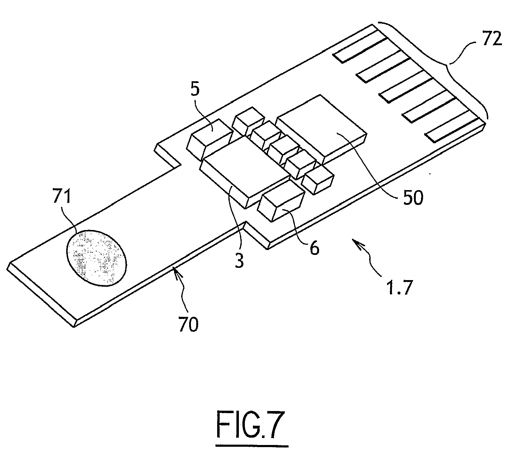

En référence à la figure 7, il est techniquement possible de réaliser une chaîne capacitive complète miniature en utilisant un circuit imprimé sur lequel on grave l'électrode de mesure, et l'on fixe à proximité un circuit intégré de mesure capacitive 3, une alimentation flottante 5, par exemple à transformateur planar, une liaison 72 avec l'extérieur, un amplificateur différentiel 6, des optocoupleurs, et un microcontrôleur 50.

Cette miniaturisation permet de réaliser des capteurs de mesure de position ou de déplacement performant dont l'habillage et l'encombrement sont similaires aux capteurs de proximité classiques (capacitif ou inductif) qui présentent des performances métrologiques très médiocres.

Une autre application non limitative d'un dispositif de mesure capacitive selon l'invention est de réaliser une jauge de contrainte sans contact avec un circuit imprimé décrit ci-dessus. En effet pour mesurer une déformation géométrique d'une pièce mécanique afin de déterminer des paramètres de contrainte mécanique (force, flexion, fatigue, charge...) les laboratoires et industriels collent des jauges de contrainte sur lesquelles sont fixés des ponts ou demi ponts d'éléments électriques, en général des résistances, dont leur valeurs électriques évoluent avec leur déformation géométrique. L'inconvénient de cette technique est la difficulté du collage (manuel, se dégrade dans le temps, coûteux) et la précision limitée entre autre par la qualité de la colle qui garantie le transfert de déformation mécanique de l'objet à contrôler à la jauge.

Un capteur complet selon l'invention, monté sur circuit imprimé, peut être fixé sur un support de référence, l'électrode visant la surface de la pièce qui subit la déformation à mesurer. En choisissant la matière constituant le circuit imprimé pour rendre l'ensemble support mécanique du capteur, circuit imprimé et la pièce qui se déforme compatibles, c'est-à-dire avec des coefficient de dérive thermique tel que l'ensemble soit très peut sensible à la température, on peut réaliser une jauge de contrainte sans contact donc sans problème de collage avec une meilleure précision très rapide (mesure dynamique), stable dans le temps et miniature.

Une application de ce type de jauge sans contact concerne par exemple le secteur de la mécatronique, notamment pour la mesure de charge radiale ou axiale que subit un roulement à bille pendant son utilisation. On peut ainsi placer un capteur complet en circuit imprimé au niveau du palier et mesurer l'affaissement du roulement à bille lors d'une charge radiale en jouant sur la raideur des lames déformables. Cette technique peut par exemple servir à mesurer le poids du linge dans une machine à laver via un roulement à bille qui maintient le tambour ou à mesurer une charge transportée par un palan.

Bien sûr, l'invention n'est pas limitée aux exemples qui viennent d'être décrits et de nombreux aménagements peuvent être apportés à ces exemples sans sortir du cadre de l'invention.

## Revendications

1. Dispositif (1.1) de mesure capacitive par pont flottant, comprenant :
- un module capteur (2.1) comprenant au moins une électrode de mesure (200) et au moins une électrode de garde (201) disposées à proximité d'une cible (7) reliée à une masse générale (M),
- une garde (25) à laquelle ladite électrode de garde (201) est reliée, et
- au moins un circuit intégré de mesure capacitive (3), comprenant (i) une entrée de mesure (+) et (ii) une sortie d'excitation (OSC) pour mesurer des capacités entre des électrodes reliées respectivement à ladite entrée de mesure (+) et à un signal d'excitation délivré par ladite sortie d'excitation (OSC), (iii) une borne de masse et (iv) une sortie de mesure (S),
**caractérisé en ce que** :
- il comprend en outre des moyens (5) pour alimenter en mode flottant ledit circuit intégré de mesure capacitive (3),
- ladite entrée de mesure (+) du circuit intégré (3) est reliée à ladite électrode de mesure (200),
- ladite garde (25) est reliée à ladite borne de masse du circuit intégré (3), et
- ladite sortie d'excitation (OSC) du circuit intégré (3) est reliée à ladite masse générale (M).

2. Dispositif (1.1) selon la revendication 1, **caractérisé en ce que** les moyens d'alimentation flottante (5) sont agencés pour procurer une isolation électrique du circuit intégré de mesure capacitive (3) par rapport à la masse générale (M).

3. Dispositif (1.1) selon l'une des revendications 1 ou 2, **caractérisé en ce qu'**il comprend en outre des moyens (6) d'amplification différentielle pour générer, à partir du signal de sortie (S) du circuit intégré de mesure capacitive (3), un signal de sortie en référence à la masse générale.

4. Dispositif (1.1) selon l'une quelconque des revendications précédentes, **caractérisé en ce qu'**il comprend en outre des moyens amplificateurs (4) disposés entre la sortie d'excitation (OSC) du circuit intégré de mesure capacitive (3) et la masse générale.

5. Dispositif selon les revendications 2 et 4, **caractérisé en ce qu'**il comprend en outre des moyens pour alimenter les moyens d'amplification à une tension pouvant être plus élevée que celle du circuit intégré de mesure capacitive.

6. Dispositif (1.2) selon l'une quelconque des revendications précédentes, comprenant en outre une seconde électrode de garde (202) entourant la première électrode de garde (201), **caractérisé en ce que** ladite seconde électrode de garde (202) est reliée à la masse générale.

7. Dispositif (1.3) selon l'une quelconque des revendications 1 à 5, dans lequel le module capteur (2.3) comprend une première et une seconde électrodes de mesure (200A, 200B) sensiblement parallèles et entre lesquelles est située une électrode cible (7) reliée à la masse générale, **caractérisé en ce que** les première et seconde électrodes de mesure (200A, 200B) sont reliées respectivement à une première et à une seconde entrées du circuit intégré de mesure capacitive (3) et sont entourées respectivement par des première et seconde électrodes de garde (204A, 204B).

8. Dispositif (1.3) selon la revendication 7, **caractérisé en ce que** les première et seconde électrodes de garde (204A, 204B) sont reliées entre elles et à la garde (25) via une liaison de garde commune (23).

9. Dispositif (1.4) selon la revendication 7, **caractérisé en ce que** les première et seconde électrodes de garde (204A, 204B) sont reliées à la garde (25) via respectivement une première et une seconde liaisons de garde (24A, 24B).

10. Dispositif (1.5, 1.6) selon l'une quelconque des revendications 1 à 5, **caractérisé en ce qu'**il comprend en outre une pluralité d'électrodes de mesure (252, 253, 254, 255) entourées par une électrode de garde (251) reliée à la garde (25', 25").

11. Dispositif (1.5) selon la revendication 10, **caractérisé en ce qu'**il comprend en outre des moyens commutateurs (8) reliés en entrée à la pluralité d'électrodes de mesure (252, 253, 254, 255) et en sortie à une entrée du circuit intégré de mesure capacitive (3), situés à l'intérieur de la garde (25') et commandés par des moyens de contrôle et de traitement (50).

12. Dispositif (1.6) selon la revendication 10, **caractérisé en ce qu'**il comprend en outre une pluralité de circuits intégrés de mesure capacitive (3.1, 3.2, 3.3, 3.4) reliés chacun en entrée à une électrode de mesure (252, 253, 254, 255) et en sortie, ayant chacun leur sortie d'excitation (OSC) reliée en entrée de premiers moyens commutateurs (8.1) dont la sortie est reliée à la masse générale, et leur sortie de mesure (S) reliée en entrée de seconds moyens commutateurs (8.2) générant en sortie un signal de mesure capacitive multiplexé, lesdits premiers et seconds moyens commutateurs (8.1, 8.2) étant situés à l'intérieur de la garde (25") et commandés par des moyens de contrôle et de traitement (50).

13. Dispositif (1.5, 1.6) selon l'une des revendications 11 ou 12, **caractérisé en ce qu'**il comprend en outre des moyens optocoupleurs (90, 91) disposés entre les moyens commutateurs (8; 8.1, 8.2) et les moyens de contrôle et de traitement (50).

14. Dispositif selon l'une quelconque des revendications précédentes, **caractérisé en ce que** le circuit intégré de mesure capacitive comprend des moyens de conversion capacitive/numérique (CDC) à transfert de charges.

15. Dispositif selon l'une quelconque des revendications 1 à 13, **caractérisé en ce que** le circuit intégré de mesure capacitive comprend un convertisseur capacitif-numérique Delta Sigma.

16. Dispositif selon l'une quelconque des revendications précédentes, dans lequel le circuit intégré de mesure capacitive est conçu pour générer des signaux de sortie numérique, **caractérisé en ce qu'**il comprend en outre des moyens optocoupleurs pour traiter les signaux de sortie du circuit intégré de mesure capacitive.

17. Dispositif selon l'une quelconque des revendications précédentes, **caractérisé en ce que** le circuit intégré de mesure capacitive est situé à proximité des électrodes du module capteur.

18. Dispositif selon l'une quelconque des revendications précédentes, **caractérisé en ce que** le circuit intégré de mesure capacitive est déporté des électrodes au moyen d'un câble coaxial ou triaxial.

19. Dispositif selon l'une quelconque des revendications précédentes, **caractérisé en ce que** le circuit intégré de mesure capacitive comprend des entrées différentielles et est à garde unique.

20. Dispositif selon l'une quelconque des revendications précédentes, **caractérisé en ce qu'**il comprend en outre des moyens d'alimentation flottante pour alimenter les composants disposés à l'intérieur de la garde.

21. Dispositif selon la revendication 20, **caractérisé en ce que** les moyens d'alimentation sont choisis parmi les moyens suivants: des moyens de conversion continu/continu (DC-DC), des moyens de conversion alternatif/continu (AC-DC), au moins une self de choc, au moins une pile électrique, au moins une batterie ou tout autre convertisseur d'énergie/DC.

22. Dispositif selon la revendication 21, dans lequel les moyens d'alimentation comprennent des moyens de conversion DC-DC ou AC-DC, **caractérisé en ce que** lesdits moyens de conversion DC-DC ou AC-DC comprennent un transformateur comportant, en tant que circuit primaire une bobine excitée par un signal alternatif référencé à une masse générale, et en tant que circuit secondaire, une bobine réceptrice connectée à des moyens redresseurs pour générer une ou plusieurs tensions continues flottantes.

23. Dispositif selon la revendication 22, **caractérisé en ce que** le transformateur est du type « planar ».

24. Dispositif miniaturisé de mesure capacitive selon l'une quelconque des revendications précédentes, **caractérisé en ce qu'**il est réalisé sous la forme d'un circuit imprimé sur lequel l'électrode de mesure est gravée, ledit circuit imprimé recevant le circuit intégré de mesure capacitive, les moyens d'alimentation flottante et des moyens de liaison du circuit intégré avec des équipements extérieurs.

25. Dispositif selon l'une quelconque des revendications précédentes, mis en oeuvre dans un système anti-collision.

26. Dispositif selon l'une quelconque des revendications 1 à 24, mis en oeuvre dans un système de reconnaissance de forme.

27. Dispositif selon l'une quelconque des revendications 1 à 24, mis en oeuvre dans une jauge de contrainte, **caractérisé en ce qu'**il est fixé sur un support de référence et présente au moins une électrode de mesure visant la surface d'une pièce subissant une déformation à mesurer.

28. Dispositif selon l'une quelconque des revendications 1 à 24, mis en oeuvre dans un système de métrologie dimensionnelle.

29. Dispositif selon l'une quelconque des revendications 1 à 24, mis en oeuvre dans un système biocapteur.

30. Dispositif selon l'une quelconque des revendications 1 à 24, mis en oeuvre pour une caractérisation de matériaux.

31. Procédé de mesure capacitive par pont flottant, comprenant des étapes :
- de disposition d'au moins une électrode de mesure (200) et d'au moins une électrode de garde (201) d'un module capteur (2.1) à proximité d'une cible (7) reliée à une masse générale (M),
- de liaison de ladite électrode de garde (201) à une garde (25),et
- de mise en oeuvre d'au moins un circuit intégré de mesure capacitive (3), comprenant (i) une entrée de mesure (+) et (ii) une sortie d'excitation (OSC) pour mesurer des capacités entre des électrodes reliées respectivement à ladite entrée de mesure (+) et à un signal d'excitation délivré par ladite sortie d'excitation (OSC), (iii) une borne de masse et (iv) une sortie de mesure (S),
**caractérisé en ce qu'**il comprend en outre des étapes :
- d'alimentation en mode flottant dudit circuit intégré de mesure capacitive (3),
- de liaison de ladite entrée de mesure (+) du circuit intégré (3) à ladite électrode de mesure (200),
- de liaison de ladite garde (25) à ladite borne de masse du circuit intégré (3), et
- de liaison de ladite sortie d'excitation (OSC) du circuit intégré (3) à ladite masse générale (M).

32. Procédé selon la revendication 31, **caractérisé en ce qu'**il comprend en outre une amplification différentielle du signal de sortie du circuit intégré de mesure capacitive, pour générer un signal de sortie en référence à la masse générale.

33. Procédé selon l'une des revendications 31 ou 32, **caractérisé en ce qu'**il comprend en outre une amplification du signal d'excitation généré par le circuit intégré de mesure capacitive.

34. Procédé selon l'une quelconque des revendications 31 à 33, mis en oeuvre dans un dispositif pourvu d'une pluralité d'électrodes de mesure, **caractérisé en ce qu'**il comprend en outre une commutation pour connecter une électrode de mesure parmi la pluralité d'électrodes de mesure en entrée du circuit intégré de mesure capacitive.

35. Procédé selon l'une quelconque des revendications 31 à 33, mis en oeuvre dans un dispositif pourvu d'une pluralité d'électrodes de mesure connectées en entrée d'une pluralité de circuits intégrés de mesure capacitive, **caractérisé en ce qu'**il comprend en outre une commutation des sorties d'excitation de la pluralité de circuits intégrés de mesure capacitive vers la masse générale et une commutation des sorties de mesure de la pluralité de circuits intégrés de mesure capacitive vers une sortie de sortie multiplexée.

## Patentansprüche

1. Vorrichtung (1.1) zur kapazitiven Messung mittels schwebender Brücke, umfassend:
- ein Sensormodul (2.1), das wenigstens eine Messelektrode (200) und wenigstens eine Schutzelektrode (201) umfasst, welche in der Nähe eines mit einer Hauptmasse (M) verbundenen Ziels (7) angeordnet sind,
- eine Schutzvorrichtung (25), mit der die Schutzelektrode (201) verbunden ist, und
- wenigstens eine integrierte Schaltung zur kapazitiven Messung (3), umfassend (i) einen Messeingang (+) und (ii) einen Erregerausgang (OSC), um Kapazitäten zwischen Elektroden, die mit dem Messeingang (+) bzw. mit einem durch den Erregerausgang (OSC) gelieferten Erregersignal verbunden sind, zu messen, (iii) einen Masseanschluss und (iv) einen Messausgang (S),
**dadurch gekennzeichnet, dass**:
- sie ferner Mittel (5) umfasst, um die integrierte Schaltung zur kapazitiven Messung (3) im schwebenden Modus zu speisen,
- der Messeingang (+) der integrierten Schaltung (3) mit der Messelektrode (200) verbunden ist,
- die Schutzvorrichtung (25) mit dem Masseanschluss der integrierten Schaltung (3) verbunden ist und
- der Erregerausgang (OSC) der integrierten Schaltung (3) mit der Hauptmasse (M) verbunden ist.

2. Vorrichtung (1.1) nach Anspruch 1, **dadurch gekennzeichnet, dass** die Mittel (5) zur schwebenden Speisung dazu ausgelegt sind, für eine elektrische Isolierung der integrierten Schaltung zur kapazitiven Messung (3) gegenüber der Hauptmasse (M) zu sorgen.

3. Vorrichtung (1.1) nach einem der Ansprüche 1 oder 2, **dadurch gekennzeichnet, dass** sie ferner Mittel (6) zur Differenzverstärkung umfasst, um anhand des Ausgangssignals (S) der integrierten Schaltung zur kapazitiven Messung (3) ein Ausgangssignal in Bezug auf die Hauptmasse zu erzeugen.

4. Vorrichtung (1.1) nach einem der vorhergehenden Ansprüche, **dadurch gekennzeichnet, dass** sie ferner Verstärkungsmittel (4) umfasst, die zwischen dem Erregerausgang (OSC) der integrierten Schaltung zur kapazitiven Messung (3) und der Hauptmasse angeordnet sind.

5. Vorrichtung nach den Ansprüchen 2 und 4, **dadurch gekennzeichnet, dass** sie ferner Mittel umfasst, um die Verstärkungsmittel mit einer Spannung zu speisen, die höher als diejenige der integrierten Schaltung zur kapazitiven Messung sein kann.

6. Vorrichtung (1.2) nach einem der vorhergehenden Ansprüche, ferner umfassend eine zweite Schutzelektrode (202), welche die erste Schutzelektrode (201) umgibt, **dadurch gekennzeichnet, dass** die zweite Schutzelektrode (202) mit der Hauptmasse verbunden ist.

7. Vorrichtung (1.3) nach einem der Ansprüche 1 bis 5, wobei das Sensormodul (2.3) eine erste und eine zweite Messelektrode (200A, 200B) umfasst, die im Wesentlichen parallel sind und zwischen denen sich eine mit der Hauptmasse verbundene Zielelektrode (7) befindet, **dadurch gekennzeichnet, dass** die erste und die zweite Messelektrode (200A, 200B) mit einem ersten bzw. mit einem zweiten Eingang der integrierten Schaltung zur kapazitiven Messung (3) verbunden sind und von einer ersten bzw. einer zweiten Schutzelektrode (204A, 204B) umgeben sind.

8. Vorrichtung (1.3) nach Anspruch 7, **dadurch gekennzeichnet, dass** die erste und die zweite Schutzelektrode (204A, 204B) untereinander und mit der Schutzvorrichtung (25) über eine gemeinsame Schutzverbindung (23) verbunden sind.

9. Vorrichtung (1.4) nach Anspruch 7, **dadurch gekennzeichnet, dass** die erste und die zweite Schutzelektrode (204A, 204B) mit der Schutzvorrichtung (25) über eine erste bzw. eine zweite Schutzverbindung (24A, 24B) verbunden sind.

10. Vorrichtung (1.5, 1.6) nach einem der Ansprüche 1 bis 5, **dadurch gekennzeichnet, dass** sie ferner eine Vielzahl von Messelektroden (252, 253, 254, 255), die von einer mit der Schutzvorrichtung (25', 25") verbundenen Schutzelektrode (251) umgeben sind, umfasst.

11. Vorrichtung (1.5) nach Anspruch 10, **dadurch gekennzeichnet, dass** sie ferner Schaltmittel (8) umfasst, die eingangsseitig mit der Vielzahl von Messelektroden (252, 253, 254, 255) und ausgangsseitig mit einem Eingang der integrierten Schaltung zur kapazitiven Messung (3) verbunden sind, innerhalb der Schutzvorrichtung (25') gelegen sind und durch Steuer- und Verarbeitungsmittel (50) gesteuert werden.

12. Vorrichtung (1.6) nach Anspruch 10, **dadurch gekennzeichnet, dass** sie ferner eine Vielzahl von integrierten Schaltungen zur kapazitiven Messung (3.1, 3.2, 3.3, 3.4) umfasst, die jeweils eingangsseitig mit einer Messelektrode (252, 253, 254, 255) verbunden sind und bei denen ausgangsseitig jeweils ihr Erregerausgang (OSC) an den Eingang von ersten Schaltmitteln (8.1), deren Ausgang mit der Hauptmasse verbunden ist, angeschlossen ist, und ihr Messausgang (S) an den Eingang von zweiten Schaltmitteln (8.2), die ausgangsseitig ein kapazitives Mess-Multiplexsignal erzeugen, angeschlossen ist, wobei die ersten und die zweiten Schaltmittel (8.1, 8.2) sich innerhalb der Schutzvorrichtung (25") befinden und durch Steuer- und Verarbeitungsmittel (50) gesteuert werden.

13. Vorrichtung (1.5, 1.6) nach einem der Ansprüche 11 oder 12, **dadurch gekennzeichnet, dass** sie ferner Optokoppler-Mittel (90, 91) umfasst, die zwischen den Schaltmitteln (8; 8.1, 8.2) und den Steuer- und Verarbeitungsmitteln (50) angeordnet sind.

14. Vorrichtung nach einem der vorhergehenden Ansprüche, **dadurch gekennzeichnet, dass** die integrierte Schaltung zur kapazitiven Messung Kapazität-Digital-Wandlermittel (CDC) mit Ladungstransfer umfasst.

15. Vorrichtung nach einem der Ansprüche 1 bis 13, **dadurch gekennzeichnet, dass** die integrierte Schaltung zur kapazitiven Messung einen Delta-Sigma-Kapazität-DigitalWandler umfasst.

16. Vorrichtung nach einem der vorhergehenden Ansprüche, wobei die integrierte Schaltung zur kapazitiven Messung dazu ausgestaltet ist, digitale Ausgangssignale zu erzeugen, **dadurch gekennzeichnet, dass** sie ferner Optokoppler-Mittel umfasst, um die Ausgangssignale der integrierten Schaltung zur kapazitiven Messung zu verarbeiten.

17. Vorrichtung nach einem der vorhergehenden Ansprüche, **dadurch gekennzeichnet, dass** die integrierte Schaltung zur kapazitiven Messung in der Nähe der Elektroden des Sensormoduls gelegen ist.

18. Vorrichtung nach einem der vorhergehenden Ansprüche, **dadurch gekennzeichnet, dass** die integrierte Schaltung zur kapazitiven Messung mittels eines Koaxial- oder Triaxialkabels von den Elektroden entfernt ist.

19. Vorrichtung nach einem der vorhergehenden Ansprüche, **dadurch gekennzeichnet, dass** die integrierte Schaltung zur kapazitiven Messung Differenzeingänge umfasst und eine einzige Schutzvorrichtung hat.

20. Vorrichtung nach einem der vorhergehenden Ansprüche, **dadurch gekennzeichnet, dass** sie ferner Mittel zur schwebenden Speisung umfasst, um die innerhalb der Schutzvorrichtung angeordneten Mittel zu speisen.

21. Vorrichtung nach Anspruch 20, **dadurch gekennzeichnet, dass** die Speisemittel aus den folgenden Mitteln ausgewählt sind: Gleichstrom-Gleichstrom (DC-DC)-Wandlermittel, Wechselstrom-Gleichstrom (AC-DC)-Wandlermittel, wenigstens eine Drosselspule, wenigstens eine elektrische Batterie, wenigstens eine Batterie oder jedweden anderen Energie/DC-Wandler.

22. Vorrichtung nach Anspruch 21, wobei die Speisemittel DC-DC- oder AC-DC-Wandlermittel umfassen, **dadurch gekennzeichnet, dass** die DC-DC- oder AC-DC-Wandlermittel einen Transformator umfassen, der als Primärkreis eine durch ein auf eine Hauptmasse bezogenes Wechselsignal erregerte Spule und als Sekundärkreis eine Empfangsspule umfasst, die an Gleichrichtermittel angeschlossen ist, um eine oder mehrere schwebende Gleichspannungen zu erzeugen.

23. Vorrichtung nach Anspruch 22, **dadurch gekennzeichnet, dass** der Transformator vom "planaren" Typ ist.

24. Miniaturisierte Vorrichtung zur kapazitiven Messung nach einem der vorhergehenden Ansprüche, **dadurch gekennzeichnet, dass** sie in Form einer gedruckten Schaltung ausgebildet ist, auf die die Messelektrode geätzt ist, wobei die gedruckte Schaltung die integrierte Schaltung zur kapazitiven Messung, die Mittel zur schwebenden Speisung und Mittel zum Verbinden der integrierten Schaltung mit außen liegenden Einrichtungen aufnimmt.

25. Vorrichtung nach einem der vorhergehenden Ansprüche, die in einem Kollisionsschutzsystem eingesetzt wird.

26. Vorrichtung nach einem der Ansprüche 1 bis 24, die in einem Formerkennungssystem eingesetzt wird.

27. Vorrichtung nach einem der Ansprüche 1 bis 24, die in einem Dehnungsmesser eingesetzt wird, **dadurch gekennzeichnet, dass** sie an einem Bezugshalter befestigt ist und wenigstens eine Messelektrode, die auf die Oberfläche eines eine zu messende Verformung erfahrenden Teils gerichtet ist, aufweist.

28. Vorrichtung nach einem der Ansprüche 1 bis 24, die in einem System dimensioneller Metrologie eingesetzt wird.

29. Vorrichtung nach einem der Ansprüche 1 bis 24, die in einem Biosensor-System eingesetzt wird.

30. Vorrichtung nach einem der Ansprüche 1 bis 24, die für eine Werkstoffcharakterisierung eingesetzt wird.

31. Verfahren zur kapazitiven Messung mittels schwebender Brücke, umfassend Schritte:
- eines Anordnens wenigstens einer Messelektrode (200) und wenigstens einer Schutzelektrode (201) eines Sensormoduls (2.1) in der Nähe eines mit einer Hauptmasse (M) verbundenen Ziels (7),
- eines Verbindens der Schutzelektrode (201) mit einer Schutzvorrichtung (25) und
- eines Einsetzens wenigstens einer integrierten Schaltung zur kapazitiven Messung (3), umfassend (i) einen Messeingang (+) und (ii) einen Erregerausgang (OSC), um Kapazitäten zwischen Elektroden, die mit dem Messeingang (+) bzw. mit einem durch den Erregerausgang (OSC) gelieferten Erregersignal verbunden sind, zu messen, (iii) einen Masseanschluss und (iv) einen Messausgang (S),
**dadurch gekennzeichnet, dass** es ferner Schritte umfasst:
- eines Speisens der integrierten Schaltung zur kapazitiven Messung (3) im schwebenden Modus,
- eines Verbindens des Messeingangs (+) der integrierten Schaltung (3) mit der Messelektrode (200),
- eines Verbindens der Schutzvorrichtung (25) mit dem Masseanschluss der integrierten Schaltung (3) und
- eines Verbindens des Erregerausgangs (OSC) der integrierten Schaltung (3) mit der Hauptmasse (M).

32. Verfahren nach Anspruch 31, **dadurch gekennzeichnet, dass** es ferner eine Differenzverstärkung des Ausgangssignals der integrierten Schaltung zur kapazitiven Messung umfasst, um ein Ausgangssignal in Bezug auf die Hauptmasse zu erzeugen.

33. Verfahren nach einem der Ansprüche 31 oder 32, **dadurch gekennzeichnet, dass** es ferner eine Verstärkung des durch die integrierte Schaltung zur kapazitiven Messung erzeugten Erregersignals umfasst.

34. Verfahren nach einem der Ansprüche 31 bis 33, das in einer Vorrichtung durchgeführt wird, die mit einer Vielzahl von Messelektroden versehen ist, **dadurch gekennzeichnet, dass** es ferner ein Umschalten umfasst, um eine Messelektrode aus der Vielzahl von Messelektroden an den Eingang der integrierten Schaltung zur kapazitiven Messung anzuschließen.

35. Verfahren nach einem der Ansprüche 31 bis 33, das in einer Vorrichtung durchgeführt wird, die mit einer Vielzahl von Messelektroden, welche an den Eingang einer Vielzahl von integrierten Schaltungen zur kapazitiven Messung angeschlossen sind, versehen ist, **dadurch gekennzeichnet, dass** es ferner ein Umschalten der Erregerausgänge der Vielzahl von integrierten Schaltungen zur kapazitiven Messung zu der Hauptmasse sowie ein Umschalten der Messausgänge der Vielzahl von integrierten Schaltungen zur kapazitiven Messung zu einem Ausgang zur gemultiplexten Ausgabe umfasst.

## Claims

1. Device (1.1) for capacitive measurement by a floating bridge, comprising:
- a sensor module (2.1) comprising at least one measuring electrode (200) and at least one guard electrode (201) arranged close to a target (7) connected to a general earth (M),
- a guard (25) to which said guard electrode (201) is connected, and
- at least one integrated circuit for capacitive measurement (3), comprising (i) a measuring input (+) and (ii) an excitation output (OSC) for measuring capacitances between electrodes respectively connected to said measuring input (+) and to an excitation signal generated by said excitation output (OSC), (iii) an earth terminal and (iv) a measuring output (S),
**characterized in that**:
- it further comprises means (5) for supplying said integrated circuit for capacitive measurement (3) in floating mode,
- said measuring input (+) of the integrated circuit (3) is connected to said measuring electrode (200),
- said guard (25) is connected to said earth terminal of the integrated circuit (3), and
- said excitation output (OSC) of the integrated circuit (3) is connected to said general earth (M).

2. Device (1.1) according to claim 1, **characterized in that** the means for floating supply (5) are arranged to achieve an electrical isolation of the integrated circuit for capacitive measurement (3), with regard to the general earth (M).

3. Device (1.1) according to one of claims 1 or 2, **characterized in that** it also comprises means (6) for differential amplification for generating, from the output signal (S) of the integrated circuit for capacitive measurement (3), an output signal referenced to the general earth.

4. Device (1.1) according to any one of the previous claims, **characterized in that** it also comprises amplification means (4) arranged between the excitation output (OSC) of the integrated circuit for capacitive measurement (3) and the general earth.

5. Device according to claims 2 and 4, **characterized in that** it also comprises means for supplying the amplification means at a voltage which can be higher than that of the integrated circuit for capacitive measurement.

6. Device (1.2) according to any one of the previous claims, also comprising a second guard electrode (202) surrounding the first guard electrode (201), **characterized in that** said second guard electrode (202) is connected to the general earth.

7. Device (1.3) according to one of claims 1 to 5, in which the sensor module (2.3) comprises a first and a second measuring electrodes (200A, 200B), substantially parallel, and between which is situated is a target electrode (7) connected to the general earth, **characterized in that** the first and second measuring electrodes (200A, 200B), are connected respectively to a first and a second inputs of the integrated circuit for capacitive measurement (3), and are surrounded respectively by first and second guard electrodes (204A, 204B).

8. Device (1.3) according to claim 7, **characterized in that** the first and second guard electrodes (204A, 204B) are connected to each other and to the guard (25) by means of a common guard connection (23).

9. Device (1.4) according to claim 7, **characterized in that** the first and second guard electrodes (204A, 204B) are connected to the guard (25) via a first and a second guard connections (24A, 24B), respectively.

10. Device (1.5, 1.6) according to any one of claims 1 to 5, **characterized in that** it also comprises a plurality of measuring electrodes (252, 253, 254, 255) surrounded by a guard electrode (251) connected to the guard (25', 25").

11. Device (1.5) according to claim 10, **characterized in that** it also comprises switching means (8) connected at input to the plurality of measuring electrodes (252, 253, 254, 255) and at output to an input of the integrated circuit for capacitive measurement (3), situated at the inside of the guard (25') and controlled by means for controling and processing (50).

12. Device (1.6) according to claim 10, **characterized in that** it also comprises a plurality of integrated circuits for capacitive measurement (3.1, 3.2, 3.3, 3.4) each connected at input to a measuring electrode (252, 253, 254, 255) and at output, each having their excitation output (OSC) connected to the input of first switching means (8.1), of which the output is connected to the general earth, and their measurement output (S) connected to the input of second switching means (8.2) generating at output a multiplexed capacitive measurement signal, said first and second switching means (8.1, 8.2) being situated inside the guard (25") and controlled by means for control and processing (50).

13. Device (1.5, 1.6) according to one of claims 11 or 12, **characterized in that** it also comprises optocoupling means (90, 91) arranged between the switching means (8; 8.1, 8.2) and the means for control and processing (50).

14. Device according to any one of the previous claims, **characterized in that** the integrated circuit for capacitive measurement comprises charge transfer capacitance/digital converter (CDC) means.

15. Device according to any one of claims 1 to 13, **characterized in that** the integrated circuit for capacitive measurement comprises a Delta Sigma capacitance-digital converter.

16. Device according to any one of the previous claims, in which the integrated circuit for capacitive measurement is designed to generate digital output signals, **characterized in that** it also comprises optocoupling means for processing the output signals of the integrated circuit for capacitive measurement.

17. Device according to any one of the previous claims, **characterized in that** the integrated circuit for capacitive measurement is situated close to the electrodes of the sensor module.

18. Device according to any one of the previous claims, **characterized in that** the integrated circuit for capacitive measurement is remote from the electrodes by means of a coaxial or triaxial cable.

19. Device according to any one of the previous claims, **characterized in that** the integrated circuit for capacitive measurement comprises differential inputs and has a single guard.

20. Device according to any one of the previous claims, **characterized in that** it also comprises means for floating supply for supplying the components arranged inside the guard.

21. Device according to claim 20, **characterized in that** the supply means are chosen from the following means: direct current / direct current (DC-DC) conversion means, alternating current / direct current (AC-DC) conversion means, at least one choke coil, at least one electrical cell, at least one battery or any other energy / DC converter.

22. Device according to claim 21, in which the supply means comprise DC-DC or AC-DC conversion means, **characterized in that** said DC-DC or AC-DC conversion means comprise a transformer comprising as primary circuit, a coil excited by an alternating signal referenced to a general earth and, as a secondary circuit, a receptor coil connected to rectifier means for generating one or a plurality of floating direct current voltages.

23. Device according to claim 22, **characterized in that** the transformer is of the "planar" type.

24. Miniaturized device for capacitive measurement according to any one of the previous claims, **characterized in that** it is produced in the form of a printed circuit on which the measuring electrode is etched, said printed circuit receiving the integrated circuit for capacitive measurement, the floating supply means, and the means of connection of the integrated circuit with external equipments.

25. Device according to any one of the previous claims, implemented in an anti-collision system.

26. Device according to any one of claims 1 to 24, implemented in a shape recognition system.

27. Device according to any one of claims 1 to 24, implemented in a strain gauge, **characterized in that** it is fixed onto a reference support and has at least one measuring electrode targeting the surface of a part being subjected to a deformation to be measured.

28. Device according to any one of claims 1 to 24, implemented in a dimensional metrology system.

29. Device according to any one of claims 1 to 24, implemented in a biosensor system.

30. Device according to any one of claims 1 to 24, implemented for a characterization of materials.

31. Method for capacitive measurement by floating bridge, comprising steps:
- of arranging at least one measuring electrode (200) and at least one guard electrode (201) of a sensor module (2.1) close to a target (7) connected to a general earth (M),
- of connecting said guard electrode (201) to a guard (25), and
- of embodying at least one integrated circuit for capacitive measurement (3), comprising (i) a measuring input (+) and (ii) an excitation output (OSC) for measuring capacitances between electrodes respectively connected to said measuring input (+) and to an excitation signal generated by said excitation output (OSC), (iii) an earth terminal and (iv) a measuring output (S),
**characterized in that** it further comprises steps:
- of supplying in floating mode said integrated circuit for capacitive measurement (3),
- of connecting said measuring input (+) of the integrated circuit (3) to said measuring electrode (200),
- of connecting said guard (25) to said earth terminal of the integrated circuit (3), and
- of connecting said excitation output (OSC) of the integrated circuit (3) to said general earth (M).

32. Method according to claim 31, **characterized in that** it also comprises a differential amplification of the output signal of the integrated circuit for capacitive measurement, for generating an output signal referenced to the general earth.

33. Method according to one of claims 31 or 32, **characterized in that** it also comprises an amplification of the excitation signal generated by the integrated circuit for capacitive measurement.

34. Method according to any one of claims 31 to 33, used in a device provided with a plurality of measuring electrodes, **characterized in that** it also comprises a switch for connecting a measuring electrode from the plurality of measuring electrodes at the input of the integrated circuit for capacitive measurement.

35. Method according to any one of claims 31 to 33, used in a device provided with a plurality of measuring electrodes connected at the input of a plurality of integrated circuits for capacitive measurement, **characterized in that** it also comprises a switch of the excitation outputs of the plurality of integrated circuits for capacitive measurement to the general earth and a switch of the measurement outputs of the plurality of integrated circuits for capacitive measurement to a multiplexed output output.
